# EUROPÄISCHE PATENTANMELDUNG

(11) **EP 1 876 257 A2**
(43) Veröffentlichungstag der Anmeldung: **09.01.2008**
(21) Anmeldenummer: 07020454.0
(22) Anmeldetag: 07.11.2000
(51) Int. Cl.: C23C 14/22, C23C 14/06, C23C 14/50

(54) **Verfahren zur PVD-Beschichtung**

(30) Priorität: 09.02.2000 DE 10005612
(62) Teilanmeldung aus: 00124166.0
(71) Anmelder: Hauzer Techno Coating BV, 5928 LL Venlo (NL)
(72) Erfinder: van der Kolk, Gerrit Jan, 6026 RG Maarheeze (NL); Hurkmans, Antonius P.A., 5062 AE Geysteren (NL); Strondl, Christian G.C., 5913 CM Venlo (NL)
(74) Vertreter: Manitz, Finsterwald & Partner GbR

(57) **Zusammenfassung**

Ein Verfahren zur Herstellung eines Gegenstandes mit einem ersten Oberflächenbereich und einem zweiten Oberflächenbereich unterschiedlicher Reibungszahl unter Anwendung einer zur Durchführung von PVD-Verfahren geeigneten Behandlungskammer vorzugsweise mit einem drehbaren Träger für den Gegenstand bzw. mehreren solcher Gegenstände, wobei mindestens zwei PVD-Beschichtungsvorgänge in der Behandlungskammer gleichzeitig durchgeführt werden, wobei der erste PVD-Beschichtungsvorgang mit einem vergleichsweise gerichteten Dampffluss von einem Target oder von mehreren Targets durchgeführt wird, das bzw. die aus einem oder mehreren der Elemente B, Si, Ti, V, Cr, Zr, Nb, Mo, Hf, Ta und W, Karbiden der genannten Elemente und Kohlenstoff besteht bzw. bestehen, und der zweite PVD-Beschichtungsvorgang mit einem vergleichsweise weniger gerichteten oder nicht gerichteten Dampffluss aus Kohlenstoff durchgeführt wird.

## Beschreibung

Die vorliegende Erfindung betrifft ein Verfahren zur Herstellung eines Gegenstandes mit einem ersten und einem zweiten Oberflächenbereich unterschiedlicher Reibungszahl unter Anwendung einer zur Durchführung von PVD-Verfahren geeigneten Behandlungskammer.

Die Erfindung befaßt sich mit einem neuen zur Erfindung gehörenden Gedanke daß es mittels PVD-Verfahren mit vernünftigem Aufwand möglich sein muß, auf einem ersten Oberflächenbereich einen relativ hohen Reibungswert und auf einem zweiten Oberflächenbereich einen relativ niedrigen Reibungswert vorzusehen.

Beispiele für Anwendungen bei denen ein solches Verfahren nützlich sein dürfte sind beispielsweise:
- Glieder von Antriebsketten, die in stufenlos variablen Getrieben eingebaut werden,
- Lager, die auf der Außenseite einen hohen Reibungswert aufweisen sollen, damit sie in einem Gehäuse schlupffrei gehalten werden können, jedoch auf der Innenseite einen niedrigen Reibungswert haben sollen, damit sie für die Lagerung einer Welle oder eines anderen Bauteils mit extrem niedrigen Abnutzungserscheinungen sorgen können,
- und Befestigungselemente und Scheiben für Befestigungselemente. Beispielsweise soll eine Unterlegscheibe für eine Mutter auf der dem Bauteil zugewandten Oberfläche einen höheren Reibungswert aufweisen, damit die Scheibe beim Anziehen der Mutter auf dem Bauteil nicht dreht und das Bauteil beschädigt, während der Reibungswert für die Paarung Scheibe/Mutter niedrig sein soll, damit die Mutter einwandfrei festgezogen werden kann, wofür eine relative Drehbewegung zwischen der Mutter und der feststehenden Scheibe erforderlich ist. be/Mutter niedrig sein soll, damit die Mutter einwandfrei festgezogen werden kann, wofür eine relative Drehbewegung zwischen der Mutter und der feststehenden Scheibe erforderlich ist.

Zur Lösung dieser Aufgabe zeichnet sich das eingangs genannte Verfahren erfindungsgemäß nach einer ersten Variante dadurch aus, daß mindestens zwei PVD-Beschichtungsvorgänge in der Behandlungskammer gleichzeitig durchgeführt werden, wobei der erste PVD-Beschichtungs-vorgang mit einem vergleichsweise gerichteten Dampffluß von einem Target oder von mehreren Targets durchgeführt wird, das bzw. die aus einem oder mehreren der Elemente B, Si, Ti, V, Cr, Zr, Nb, Mo, Hf, Ta und W, Karbiden der genannten Elemente und Kohlenstoff besteht bzw. bestehen, und der zweite PVD-Beschichtungsvorgang mit einem vergleichsweise weniger gerichteten oder nicht gerichteten Dampffluß aus Kohlenstoff durchgeführt wird.

Die Erfindung basiert auf der Erkenntnis, daß Beschichtungen die aus Karbiden der genannten Elemente und Kohlenstoff bestehen, insbesondere Beschichtungen mit eingebautem Wasserstoff eine Reibungszahl aufweisen, die von der Zusammensetzung der Schicht abhängig ist. Beispielsweise weist eine Beschichtung B₄C-C:H mit 55 atomaren % Bor und demzufolge 45 atomaren % C:H eine Reibungszahl von 0,2 auf, während die gleiche Beschichtung bei 80 atomaren % Bor eine Reibungszahl von 0,9 aufweist.

Eine kompositionsabhängige Reibungszahl ist bei all den genannten Elementen festzustellen, obwohl die genauen Zusammensetzungen, die erforderlich sind, um deutlich unterschiedliche Reibungszahlen zu erzeugen, jeweils anders sind. Beispielsweise gilt für Wolfram, daß eine Komposition W-C:H mit 50 % W eine hohe Reibungszahl aufweist, während bei 15 % W und demzufolge höheren Kohlenstoffanteil sich eine niedrige Reibungszahl ergibt.

Durch die Ablagerung der Karbidschicht von einem vergleichsweise gerichteten Dampffluß erfolgt diese Beschichtung bevorzugt auf dem Oberflächenbereich der senkrecht zum Dampffluß steht und diesem zugewandt ist, während eine weitaus dünnere Beschichtung sich auf Flächen aufbaut, die nicht senkrecht zum Dampffluß stehen, d.h. diesem nicht zugewandt sind.

Dadurch, daß der Kohlenstoffdampffluß vergleichsweise weniger gerichtet ist bzw. ungerichtet, d.h. de facto eine Kohlenstoffwolke bildet, ist der Kohlenstoff im gleichen Maß an allen Oberflächenbereichen mit einer in etwa konstanten Verteilungsdichte anwesend. Da der Kohlenstoff auf dem ersten Oberflächenbereich mit einem größeren Angebot an Karbidmolekülen sich vermengt, erfolgt dort eine Beschichtung mit verhältnismäßig wenig Kohlenstoff, während an dem zweiten Oberflächenbereich, wo verhältnismäßig wenig Moleküle des Karbids aufgrund der gerichteten Eigenschaften des Dampfflusses sich ablagern, eine hohe Kohlenstoffkonzentration erreicht wird.

Somit sind auf den zwei genannten Oberfächenbereichen unterschiedliche Kohlenstoffanteile vorhanden, die zu den erfindungsgemäß gewünschten unterschiedlichen Reibungszahlen an diesen Oberflächenbereichen führen.

Es ist zwar streng genommen zur Durchführung des erfindungsgemäßen Verfahrens nicht erforderlich, irgendwelche Bewegungen des Gegenstandes vorzusehen, gerade dann nicht, wenn nur ein einzelner Gegenstand beschichtet werden soll. Aus Gründen der Verfahrensökonomie und der Erzeugung einer gleichmäßigen Beschichtung ist es aber angebracht, den Gegenstand bzw. mehrere Gegenstände auf einem drehbaren Träger in an sich bekannter Weise anzuordnen.

Die zwei PVD-Beschichtungsvorgänge können auf verschiedene Weise realisiert werden.

Es ist beispielsweise möglich, die zwei PVD-Beschichtungsvorgänge durch die Benutzung einer einzigen PVD-Beschichtungseinrichtung durchzuführen. Um dies zu realisieren, wird, entsprechend Anspruch 2, so vorgegangen, daß mit einem oder mehreren Targets unter Anwendung eines Kathodenzerstäubungsverfahrens oder eines Lichtbogenverdampfungsverfahrens ein Metalldampf oder Metall- und Karbidionen erzeugt und als gerichteter Dampffluß auf den Gegenstand gerichtet wird bzw. werden, wobei das Kathodenzerstäubungsverfahren oder das Lichtbogenverdampfungsverfahren zur Erzeugung eines Plasmas in der Behandlungskammer führt bzw. beiträgt und hierdurch Kohlenstoffionen und -moleküle aus einer sich in der Behandlungskammer befindlichen Kohlenwasserstoffatmosphäre in Form eines weniger gerichteten oder ungerichteten Dampfflusses entstehen und zumindest teilweise in die auf den Gegenstand sich ausbildende Beschichtung eingebaut werden.

Die Kohlenstoffionen und -moleküle werden somit in einem Plasma erzeugt, das durch den Betrieb einer Kathode (Target) im Kathodenzerstäubungsmodus oder Lichtbogenverdampfungsmodus sowieso vorhanden ist. Dieses Plasma kann auch durch die Anwendung von gezielten Magnetfeldern ausgedehnt werden, um das Angebot an Kohlenstoffionen und - molekülen zu erhöhen und dies vor allem in den Bereich des Gegenstandes zu bringen. Die Magnetfelder können auch die Magnetfelder sein, die für den Betrieb der Kathode als unbalanzierter Magnetron benötigt werden.

Eine andere Möglichkeit, die zwei PVD-Beschichtungsvorgänge durchzuführen, liegt darin, erste und zweite PVD-Beschichtungseinrichtungen in der Behandlungskammer zu benutzen, wobei die Anordnung so getroffen werden kann, daß mindestens eine erste PVD-Beschichtungseinrichtung und eine zweite PVD-Beschichtungseinrichtung in der Behandlungskammer zur Anwendung kommen, wobei die erste PVD-Beschichtungseinrichtung einen vergleichsweise gerichteten Dampffluß von einem Target oder von mehreren Targets erzeugt, das bzw. die aus einem oder mehreren der Elemente B, Si, Ti, V, Cr, Zr, Nb, Mo, Hf, Ta und W, Karbiden der genannten Elemente und Kohlenstoff besteht bzw. bestehen, und die zweite PVD-Beschichtungseinrichtung einen vergleichsweise weniger gerichteten oder nicht gerichteten Dampffluß aus Kohlenstoff erzeugt.

Zur Durchführung des erfindungsgemäßen Verfahrens nach der ersten Variante kann der Gegenstand bzw. können mehrere Gegenstände auf einem drehbaren Träger angeordnet werden und durch eine Drehbewegung des Trägers durch den vergleichsweise gerichteten Dampffluß der ersten PVD-Beschichtungseinrichtung hindurch bewegt werden, wobei diese Drehbewegung entweder eine einfache Drehbewegung ist, so daß der Gegenstand bzw. jeder Gegenstand eine vorgegebene, zumindest im wesentlichen konstante, effektive Orientierung zum genannten Dampffluß aufweist, oder eine komplexe Drehbewegung ist, beispielsweise eine Drehbewegung, bei der der Gegenstand bzw. jeder Gegenstand um die eigene Achse gedreht wird, wobei im Falle einer komplexeren Drehbewegung die einzelnen Drehbewegungen so synchronisiert sind, daß der Gegenstand bzw. jeder Gegenstand ebenfalls eine vorgegebene, zumindest im wesentlichen konstante, effektive Orientierung zum genannten Dampffluß aufweist.

Dadurch, daß die effektive Orientierung des Gegenstandes zum gerichteten Dampffluß der ersten PVD-Beschichtungseinrichtung stets gleich ist, wird der erste Oberflächenbereich bevorzugt beschichtet. Dadurch, daß der Dampffluß aus Kohlenstoff weniger gerichtet ist, ist er an allen Oberflächenbereichen vorhanden, wodurch die unterschiedlichen Kompositionen auf den ersten und zweiten Oberflächenbereichen entstehen, wie oben erläutert. Bei der ersten, einen vergleichsweise gerichteten Dampffluß erzeugenden PVD-Beschichtungseinrichtung kann es sich um eine oder mehrere der folgenden Beschichtungseinrichtungen handeln:
- eine Lichtbogenverdampfungseinrichtung,
- eine Kathodenzerstäubungseinrichtung, vorzugsweise in Form eines unbalanzierten Magnetrons,
- eine lineare Ionenquelle, insbesondere eine solche zur Erzeugung von gerichteten Kohlenstoffionen, wie beispielsweise eine Plasma erzeugende Quelle mit Heizfilament.

Bei der zweiten, einen vergleichsweise weniger gerichteten oder nicht gerichteten Dampffluß erzeugenden PVD-Beschichtungseinrichtung handelt es um eine oder mehrere der folgenden Beschichtungseinrichtungen:
- eine Ionenquelle, insbesondere zur Erzeugung von Kohlenstoffionen aus einem der Behandlungskammer zugeführten gasförmigen Kohlenwasserstoff,
- eine Plasmaquelle, beispielsweise mit einem von einer Mikrowellenquelle, insbesondere einer Hochleistungs-Mikrowellenquelle, erzeugten Plasma.

Eine zweite Lösung der der Anmeldung zugrunde liegenden Aufgabe zeichnet sich bei einem Verfahren der eingangs genannten Art dadurch aus, daß mindestens eine erste PVD-Beschichtungseinrichtung und eine zweite PVD-Beschichtungseinrichtung in der Behandlungskammer zur Anwendung kommen, daß der Gegenstand oder mehrere Gegenstände auf einem drehbaren Träger angeordnet ist bzw. sind, daß der bzw. jeder Gegenstand darüber hinaus um die eigene Achse auf dem drehbaren Träger drehbar ist, und daß die Drehbewegung um die eigene Achse und die Drehbewegung um die Drehachse des Trägers derart synchronisiert sind, daß der erste Oberflächenbereich bevorzugt von der ersten Beschichtungseinrichtung und der zweite Oberflächenbereich bevorzugt von der zweiten Beschichtungseinrichtung beschichtet werden.

Bei dieser Variante der Erfindung wird hauptsächlich mit zwei gerichteten Dampfflüssen gearbeitet: einerseits aus Metal- , B- und/oder Si-Atomen oder Ionen und Kohlenstoff, die zur Bildung eines Karbids auf dem Gegenstand führen, und andererseits aus Kohlenstoff, wobei durch besondere Synchronisation der Drehbewegungen des Gegenstandes bzw. der Gegenstände auch hier unterschiedliche Kohlenstoffanteile auf dem ersten und zweiten Oberflächenbereich erzeugt werden können und somit auch die gewünschten unterschiedlichen Reibungszahlen.

Wenn man besonders geschickt vorgehet, kann man auch dafür sorgen, daß auf dem zweiten Oberflächenbereich mit der niedrigen Reibungszahl eine mehrlagige Beschichtung aufgebaut wird, die genau in der gleichzeitig eingereichten deutschen Patentanmeldung mit der Bezeichnung "Verfahren zur Herstellung von Beschichtungen sowie Gegenstand" (Anwaltsaktenzeichen H 3307) beschrieben ist, bei der eine extrem harte abnutzungsresistente und elastische Oberfläche mit niedriger Reibungszahl erzeugt werden kann.

Der Inhalt dieser gleichzeitig eingereichten Anmeldung wird aufgrund des oben gemachten Hinweises auch zur Offenbarung der vorliegenden Anmeldung gemacht.

Besonders bevorzugte Ausführungsformen der Erfindung lassen sich den weiteren Verfahrensansprüchen entnehmen.

Die vorliegende Erfindung umfaßt aber auch Gegenstände mit entsprechenden Beschichtungen sowie durch die Ansprüche 24 bis 30 definiert.

Die Erfindung wird nachfolgend näher erläutert anhand von Ausführungsbeispielen unter Bezugnahme auf die Zeichnung, die zeigt:
- Fig. 1: eine graphische Darstellung der Abhängigkeit der Reibungszahl der Zusammensetzung B4C-C:H als Funktion des B-Anteils in at%,
- Fig. 2: eine Darstellung des üblichen Dampfflusses von einer PVD-Beschichtungseinrichtung mit einem vergleichsweise gerichteten Dampffluß, beispielsweise von einer Lichtbogenverdampfungseinrichtung oder einer Kathodenzerstäubungseinrichtung,
- Fig. 3: eine Darstellung des Dampfflusses einer PVD-Beschichtungseinichtung mit einem vergleichsweise wenig gerichteten oder ungerichteten Dampffluß,
- Fig. 4: eine schematische Darstellung einer an sich bekannten PVD-Beschichtungseinrichtung, die in der europäischen Patentanmeldung mit der Veröffentlichungsnummer 0439561 beschrieben ist und die in leicht modifizierter Form für die Durchführung des vorliegenden Verfahrens bestens geeignet ist,
- Fig. 5: eine schematische Darstellung einer modifizierten Version der Vorrichtung gemäß Fig. 4 zur Durchführung der ersten Variante des erfindungsgemäßen Verfahrens,
- Fig. 6, 7 und 8: weitere mögliche Abwandlungen der Vorrichtung gemäß Fig. 4 zur Durchführung der ersten Variante des erfindungsgemäßen Verfahrens,
- Fig. 9-11: drei weitere mögliche Abwandlungen der Vorrichtung der Fig. 4 zur Durchführung der zweiten Variante des erfindungsgemäßen Verfahrens und
- Fig. 12 und Fig. 13: Darstellungen von zwei verschiedenen Beschichtungen, die mit dem erfindungsgemäßen Verfahren erzeugt werden können.

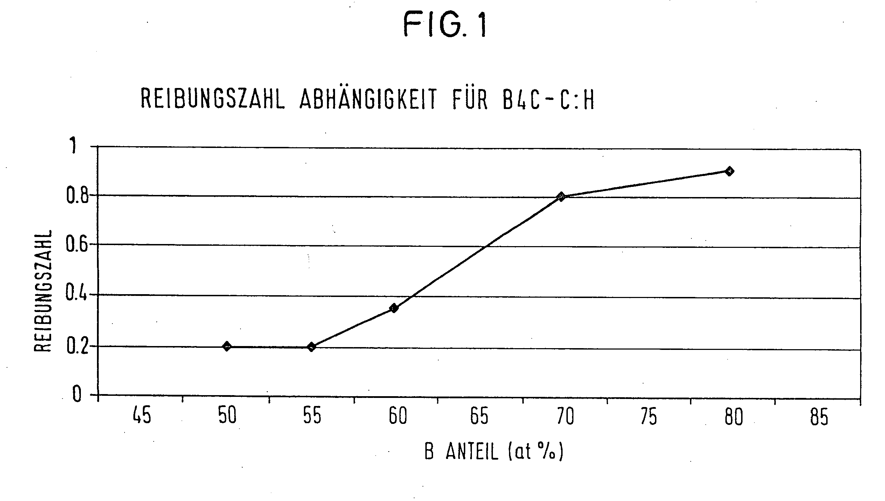

Bezugnehmend auf Fig. 1 ist ersichtlich, daß die Reibungszahl eines Materials mit der Zusammensetzung B4C-C:H eine starke Abhängigkeit vom Bor-Anteil in at% aufweist. Die niedrigste Reibungszahl von 0,2 wird erreicht mit Bor-Anteilen im Bereich zwischen 50 und 55 at%, während bei höheren Bor-Anteilen die Reibungszahl kontinuierlich steigt bis zu einem Maximalwert von 0,9 bei 80 at% Bor. Ähnliche Kurven können für alle Elemente aufgezeichnet werden, die für die vorliegende Erfindung in Frage kommen, nämlich B, Si, Ti, V, Cr, Zr, Nb, Mo, Hf, Ta und W. Alle diese Elemente bilden entsprechende Karbide und können mit unterschiedlichen Kohlenstoffanteilen über einen breiten Bereich vermengt werden, um Kompositionen zu erzeugen, die für den Zweck der vorliegenden Erfindung in Frage kommen. Auch können Kohlenstoffatome Bindungen mit Wasserstoff eingehen, wobei Wasserstoff im Regelfall zu einer Herabsetzung der Reibungszahl führt.

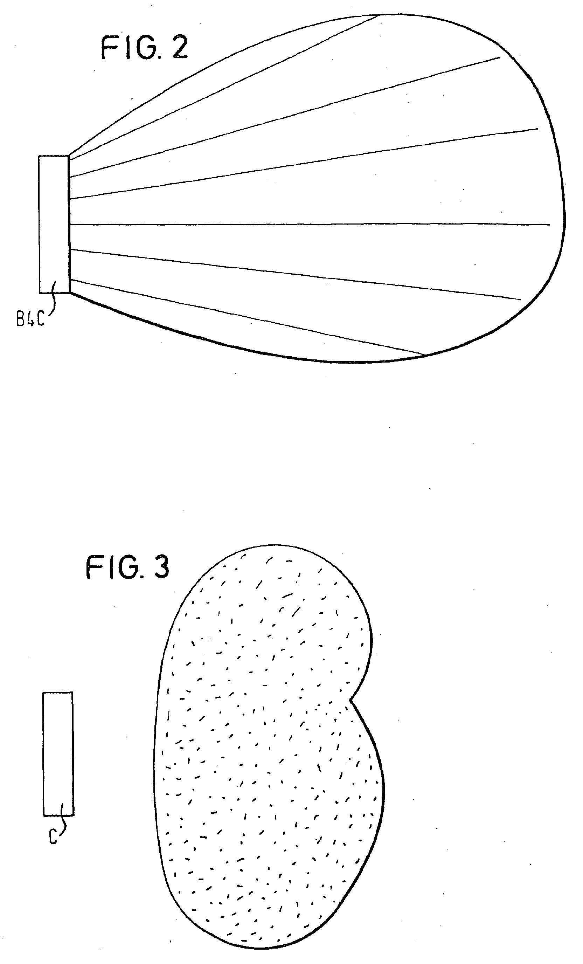

Fig. 2 zeigt auf schematische Weise die Richtungsabhängigkeit des Dampfflusses einer PVD-Beschichtungseinrichtung mit, in diesem Beispiel, einer Kathode aus B₄C, bei der die Kathode als Teil eines unbalanzierten Magnetrons betrieben wird. Diese Verteilung ist allgemein unter der Bezeichnung "Cos ϕ Verteilung" bekannt und gilt sowohl für Kathodenzerstäubungsverfahren wie auch Lichtbogenverdampfungsverfahren und im wesentlichen auch für andere gerichtete PVD-Verfahren.

Fig. 3 zeigt dagegen ein Kohlenstoffplasma, das in diesem Beispiel von einem Graphittarget erzeugt wird und durch eine Hochleistungs-Mikrowellenquelle im Plasmazustand gehalten wird. Die Ionen und Atome, die sich im Bereich des Plasmas befinden, haben hier keine bevorzugte Strömungsrichtung, sondern nur stochastisch verteilte Bewegungsrichtungen, so daß sie im wesentlichen eine gleichmäßige Kohlenstoffverteilung oder -wolke bilden.

Eine solche gleichmäßige Verteilung oder eine ähnliche Verteilung mit zwar teilweise gleichgerichteten Bewegungen, jedoch Bewegungen der Ionen und Atome in allen Richtungen ergibt sich auch für andere PVD-Beschichtungseinrichtungen, die für den Zweck der vorliegenden Erfindung als vergleichsweise weniger gerichteten oder ungerichteten Kohlenstoffquellen gelten.

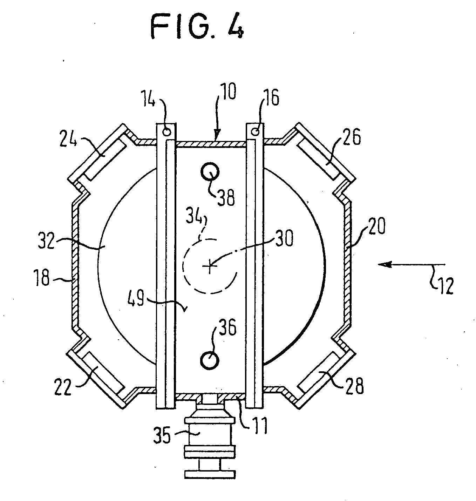

Bezugnehmend auf Fig. 4 ist hier eine schematische Darstellung einer PVD-Beschichtungseinrichtung zu sehen, die nach dem europäischen Patent 0 439 561 aufgebaut ist und entsprechend den dort angegebenen Beispielen betrieben werden kann. In diesem Zusammenhang wird auf die Veröffentlichung "Surface and Coating Technology" Heft 50 (1992) Seiten 169 bis 178, "A new method for hard coatings" by W. Münz, D. Schultze und F.G.M. Hauzer verwiesen.

In der in Fig. 4 gezeigten Form weist die Behandlungskammer 10 ein mittleres, in Seitenansicht, d.h. in Richtung des Pfeils 12 der Fig. 4, zumindest im wesentlichen rechteckigen Gehäuseteil 11 auf, an dem links und rechts zwei um jeweilige vertikale Schwenkachsen 14, 16 angebrachten aufschwenkbaren Kammertüren 18, 20 vorgesehen sind.

In jeder der Kammertüren 18 und 20 sind zwei Targets 22, 24 bzw. 26 und 28 angebracht. Die gesamte Struktur im geschlossenen Zustand gemäß Fig. 4 ist im Querschnitt im wesentlichen achteckig. Jedes Target 22 bis 28 weist in Richtung der Drehachse 30 eines Trägers 32, der um die Drehachse in Pfeilrichtung 34 drehbar ist (auch eine Drehung in der umgekehrten Richtung wäre denkbar). Das Bezugszeichen 35 deutet auf eine Hochleistungsvakuumpumpe hin, die in an sich bekannter Weise zur Erzeugung des notwendigen Unterdrucks in der Behandlungskammer sorgt.

Das Bezugszeichen 36 deutet auf eine Zufuhrstütze für Inertgas, beispielsweise Argon, während das Bezugszeichen 38 auf eine Zuführung für ein aus Kohlenwasserstoff bestehendes Gas hinweist.

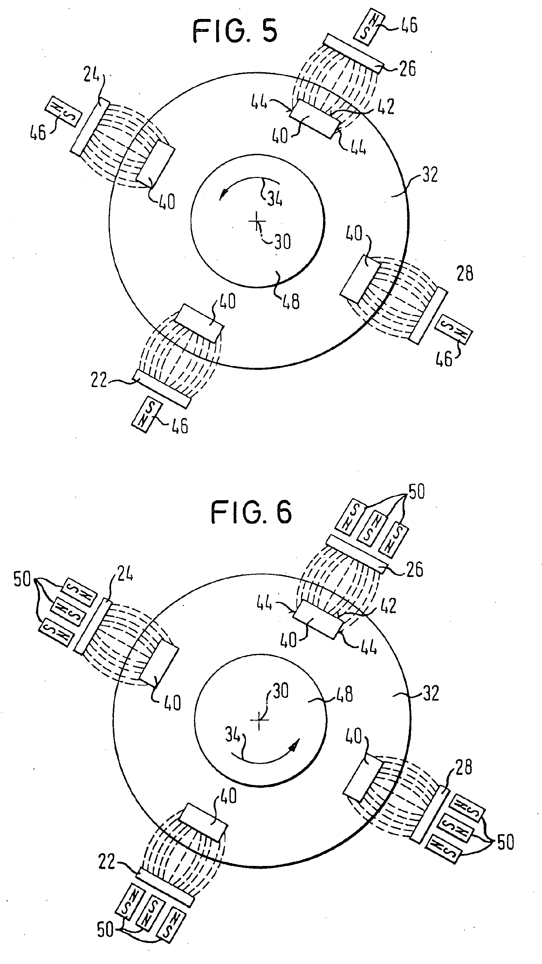

Bei der Fig. 5 und den nachfolgenden Figuren 6 bis 11 werden der Einfachheit halber nur der drehbare Träger 32 und einzelne Targets 22 bis 28 gezeigt, jedoch auch zu beschichtende Gegenstände 40 und mehrere unterschiedliche PVD-Beschichtungseinrichtungen.

Jeder zu beschichtende Gegenstand 40 weist im Beispiel der Fig. 5 und in den nachfolgenden Beispielen einen ersten Oberflächenbereich 42 auf, der mit einer Beschichtung mit einer verhältnismäßig hohen Reibungszahl zu versehen ist, und zwei Seitenflächen 44, die jeweils einen zweiten Oberflächenbereich bilden und mit einer Beschichtung versehen werden sollen, die eine niedrige Reibungszahl ermöglicht.

Es versteht sich, daß die Gegenstände 40 hier rein beispielhaft gezeigt sind und daß die zu beschichtenden Gegenstände keine besondere Form aufweisen müssen. Sie müssen lediglich mindestens zwei unterschiedliche Oberflächenbereiche aufweisen, die mit Beschichtungen unterschiedlicher Reibungszahl versehen werden sollen und zu diesem Zweck räumlich auseinander, nebeneinander und/oder mit unterschiedlichen Winkeln zueinander liegen müssen.

In Fig. 5 bestehen die vier Targets 22 bis 28 aus B₄C und werden - wie durch die Permanentmagneten 46 angedeutet - hier in an sich bekannter Weise im Lichtbogenverdampfungsmodus betrieben. Es entsteht hierdurch ein vergleichsweise gerichteter Dampffluß nach Fig. 2, so daß hierdurch hauptsächlich der erste Oberflächenbereich 42 der vier gezeigten Gegenstände 40 beschichtet werden. Eine Beschichtung erfolgt aber auch auf die Seitenflächen 44, ist jedoch eine dünnere Beschichtung, da diese Seitenflächen dem gerichteten Dampffluß nicht zugewandt sind.

Das Bezugszeichen 48 deutet hier auf eine Kohlenstoffquelle hin, beispielsweise in Form eines Graphittargets, das an der oberen Wand 50 des mittleren Teils 11 der Behandlungskammer gemäß Fig. 4 montiert ist und zur Erzeugung eines Dampfflusses entweder als eine Lichtbogenverdampfungseinrichtung oder als eine Kathodenzerstäubungseinrichtung betrieben wird, wobei mittels einer Hochleistungs-Mikrowellenquelle der Dampffluß in ein ausgedehntes, richtungsunabhängiges Kohlenstoffplasma umgewandelt wird (nicht gezeigt), das die vier Gegenstände 40 umfaßt.

Somit ist Kohlenstoff an allen Oberflächen des Gegenstandes 40 gleichermaßen vorhanden. Dies führt auf die oben angedeutete Weise zu einem erhöhten Kohlenstoffanteil an den Seitenflächen 44 und einem niedrigeren Kohlenstoffanteil an den Oberflächenbereichen 42 der Gegenstände 40. Zusätzlich zu dieser Anordnung wird über die Zuführung 38 in an sich bekannter Weise ein Kohlenwasserstoffgas, bspw. C₂H₂, der Behandlungskammer zugeführt. Dieses wird aufgrund der in der Kammer herrschenden Bedingungen in Kohlenstoff und Wasserstoff aufgespalten. Der Kohlenstoff kann ebenfalls auf den Gegenständen 40 abgelagert werden. Wichtig ist aber auch, daß der Wasserstoff teilweise in die Beschichtungen auf die Flächen 42 und 44 eingebaut wird und zwar im dort vorhandenen Kohlenstoffanteil. Dieser Wasserstoff hilft bei den Flächen 44 mit hohem Kohlenstoffanteil, die Reibungszahl dort herabzusetzen.

Die Anordnung gemäß Fig. 6 entspricht weitestgehend der Anordnung gemäß Fig. 5, weshalb für gleiche Bestandteile gleiche Bezugszeichen verwendet werden und die gleiche Beschreibung für Teile mit den gleichen Bezugszeichen gilt, so daß diese Teile nicht gesondert beschrieben werden. Diese Konvention gilt auch für die weitere Beschreibung. Unterschiedlich zur Anordnung gemäß Fig. 5 ist hier lediglich, daß die vier Targets aus B₄C in an sich bekannter Weise als unbalanzierte Magnetrons betrieben werden, was durch die unterschiedliche Darstellung der Permanentmagneten, hier mit den Bezugszeichen 50 identifiziert, dargestellt ist.

Es soll hier zum Ausdruck gebracht werden, was auch für die Fig. 5 Darstellung gilt, daß durch die einfache Drehung des Trägers 32 um die Drehachse 30 der Oberflächenbereich 42 stets die vorgegebene, zumindest im wesentlichen konstante, effektive Orientierung zum Dampffluß aufweist. Die Orientierung ist streng genommen nicht konstant und zwar einerseits aufgrund der Drehbewegung des Trägers 32 und andererseits weil der Dampffluß nicht streng parallel ausgerichtet ist, solche Winkelabhängigkeiten sind jedoch ohne Bedeutung, weshalb von einer zumindest im wesentlichen konstanten effektiven Orientierung gesprochen wird. Durch die Drehbewegung wird sichergestellt, daß auch hier eine gleichmäßige Beschichtung entsteht. Die Drehbewegung ist auch zum Teil dafür verantwortlich, daß die Seitenflächen 44 mindestens zeitweise in Berührung mit dem Dampffluß kommen, so daß auch hier eine Beschichtung entsteht, auch wenn - wie gewollt - diese Beschichtung eine kleinere Dicke aufweist als die Beschichtung auf der Oberfläche 42.

Obwohl in den Beispielen gemäß Figur 5 und 6 die Kohlenstoffquelle 48 in Form eines Graphittargets verwendet wird, kann diese Quelle weggelassen werden, und man kann sich darauf verlassen, daß das Kohlenwasserstoffgas, beispielsweise C₂H₂, das der Behandlungskammer zugeführt wird, aufgrund des vor jedem Target 24 bis 40 entstehenden Plasmas in Kohlenstoffionen und -moleküle aufgespalten wird, die dann als ungericheter Dampffluß oder als wenig gerichteter Dampffluß zumindest teilweise in die auf den Gegenständen 40 entstehende Beschichtung aufgenommen werden.

Es leuchtet ein, daß eine Beschichtung der Gegenstände 40 bei der Ausführung gemäß Fig. 5 und Fig. 6 auch dann möglich wäre, wenn keine Drehbewegung erfolgen würde, weil auch dann eine gewisse Beschichtung auf den Seitenflächen 44 erreicht wird. Die Anordnung mit der Drehbewegung 34 des Trägers 32 ist jedoch bevorzugt.

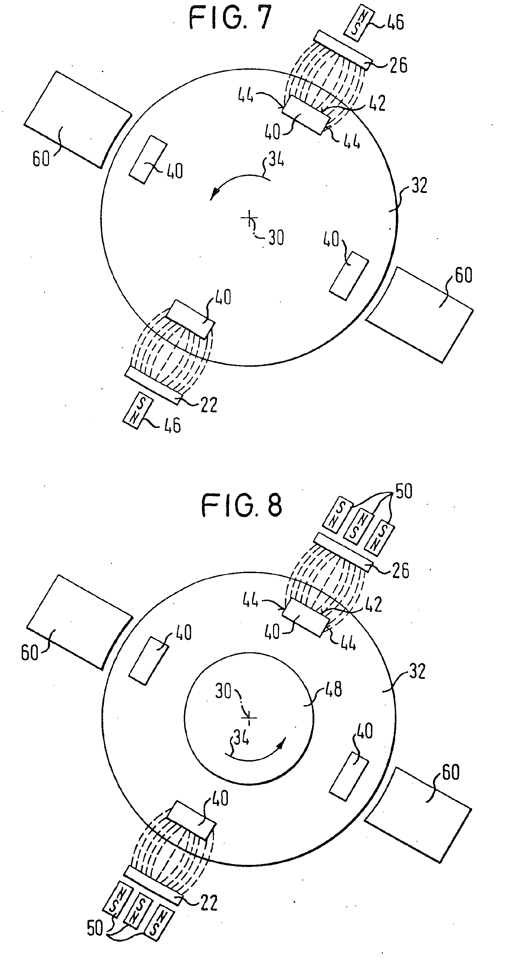

Auch bei der Anordnung gemäß Fig. 7 werden für Bestandteile, die in Fig. 5 zu finden sind, die gleichen Bezugszeichen verwendet. Es gilt wie bisher die gleiche Beschreibung. Unterschiedlich bei der Darstellung der Fig. 7 ist jedoch, daß die Kohlenstoffquelle 48 an der oberen Wand 50 der Behandlungskammer 10 hier weggelassen wird. Es werden anstelle der bisherigen Targets 24 und 28 zwei Ionenquellen 60 vorgesehen, die einen zumindest im wesentlichen nicht gerichteten Dampffluß bzw. einen ungerichteten Dampffluß aus Kohlenstoffionen und -atomen erzeugen. Die Targets 26 und 22 werden hier in einem Lichtbogenverdampfungsmodus betrieben, was durch die Magneten 46 angedeutet ist. Die Drehbewegung 34 um die Drehachse 30 ist hier zwingend erforderlich. Es entsteht wie bisher durch diese Anordnung eine dickere Beschichtung aus B₄C mit niedrigerem Kohlenstoffanteil (ggf. mit eingebautem Wasserstoff) auf dem ersten Oberflächenbereich 42 und eine dünnere Beschichtung mit einem höheren Kohlenstoffanteil (vorzugsweise mit eingebautem Wasserstoff) auf die Seitenflächen 44.

Fig. 8 zeigt eine Anordnung, die der Anordnung gemäß Fig. 7 sehr ähnlich ist; nur werden hier die Targets 26 und 22 als unbalanzierte Magnetrons betrieben, was durch die Anordnung der Permanentmagnete 50 angedeutet ist. Das Bezugszeichen 48 in dieser Figur zeigt, daß die Kohlenstoffquelle der Fig. 5 hier auch wahlweise zum Einsatz gelangen kann, was im Prinzip auch bei der Fig. 7 Ausführung möglich wäre.

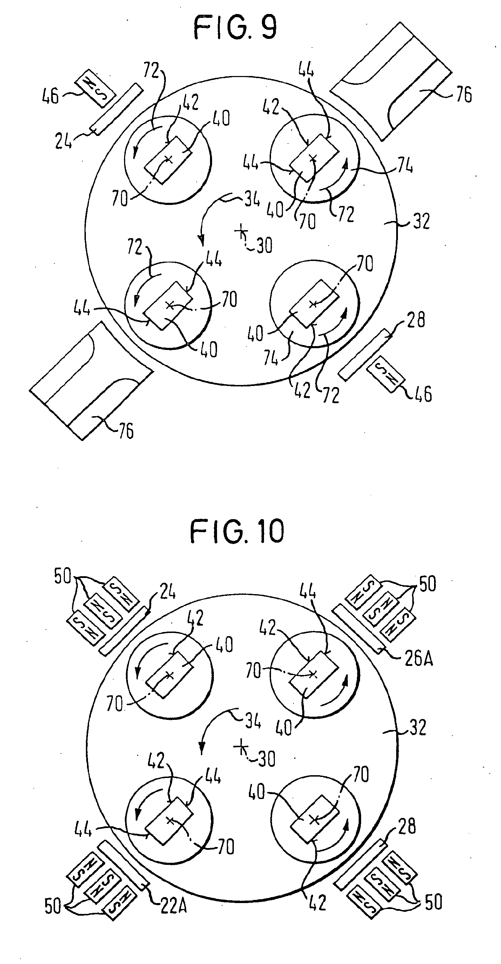

Fig. 9 zeigt eine weitere mögliche Ausführungsform. Hier sind die Gegenstände 40 nicht nur auf dem drehbaren Träger 32 mit diesem um die Drehachse 30 entsprechend dem Pfeil 34 drehbar, sondern sie sind auch um eine eigene Achse 70 entsprechend den Pfeilen 72 drehbar, was dadurch realisiert wird, daß jeder Gegenstand 40 auf einem eigenen Halter 74 montiert wird, wobei die Halter 74 um die Achse 70 gegenüber dem Träger 32 drehbar sind.

Die Bezugszeichen 24 und 28 deuten auch hier - entsprechend der angewandten Konvention bezüglich Bezugszeichen - auf Targets aus B₄C hin, die im Lichtbogenverdampfungsmodus betrieben werden, wie durch die Permanentmagnete 46 angedeutet. Die Bezugszeichen 76 deuten hier auf Kohlenstoffionenquellen hin, die hier aber als lineare, d.h. gerichtete, Ionenquellen ausgebildet sind.

Fig. 9 zeigt nämlich eine Variante, bei der die erfindungsgemäße Beschichtung auf unterschiedlichen Oberflächenbereichen 42 und 44 durch die Anwendung zweier gerichteter PVD-Beschichtungseinrichtungen erzeugt werden kann. Diese Erzeugung der unterschiedlichen Beschichtungen auf den Oberflächenbereichen 42 und 44 erfordert, daß die Drehbewegung der Gegenstände 40 um die eigene Achse 70 mit der Drehbewegung des Trägers 32 um die Drehachse 30 synchronisiert ist, und zwar auf die Art und Weise, die in Fig. 9 angedeutet ist. Man sieht nämlich, daß die Fläche 42 stets den zwei Lichtbogenverdampfungsquellen 24 und 28 zugewandt ist, so daß dieser Oberflächenbereich bevorzugt von den entsprechenden Quellen beschichtet wird und eine vergleichsmäßig dünnere Beschichtung auf die Seitenflächen 44 entsteht. Die Seitenflächen 44 sind jedoch aufgrund der Drehung um die eigene Achse bevorzugt von den Ionenquellen 76 beschichtet, so daß dort mehr Kohlenstoff geboten wird und mehr Kohlenstoff in die Beschichtung eingebaut wird.

Die Ausführungsform gemäß Fig. 10 ist im Prinzip ähnlich, nur werden hier vier Kathodenzerstäubungsquellen verwendet, um die Beschichtung zu erzeugen. Die Targets 24 und 28 bestehen wiederum aus B₄C, während die weiteren Targets 22A und 26A aus Graphit bestehen. Das heißt, es entstehen an allen vier Targets gerichtete Dampfflüsse, und zwar aus Kohlenstoff bei den Targets 22A und 26A und aus B₄C bei den Targets 24 und 28, so daß durch die synchronisierte Drehung der Gegenstände 40 um die eigene Achse 70 und auf dem Träger 32 um die Drehachse 30 ebenfalls die erfindungsgemäß gewünschte Beschichtung erzielt wird.

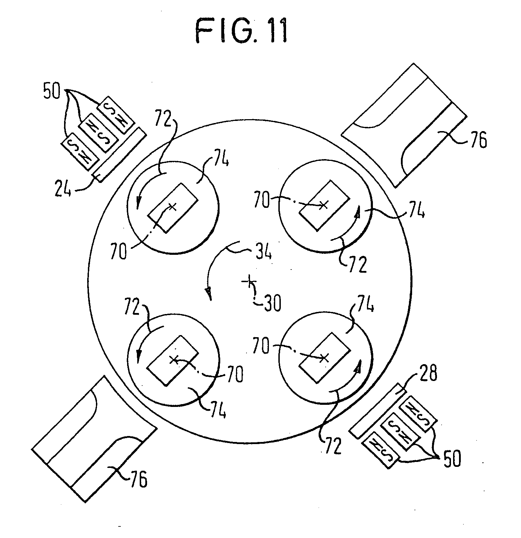

Schließlich zeigt Fig. 11, daß die gleiche Realisierung der Erfindung erreicht werden kann, wenn anstelle der zwei Lichtbogenverdampfungsquellen 24 und 28 gemäß Fig. 9 zwei entsprechende Kathodenzerstäubungsquellen verwendet werden. In allen Ausführungsbeispielen wird vorzugsweise ein Kohlenwasserstoffgas, vorzugsweise als C₂H₂, über die Zuführung 38 der Behandlungskammer zugeführt, um hauptsächlich Wasserstoff in den Kohlenstoff der Beschichtung einzubauen, um hierdurch bei den Beschichtungen mit höherem Kohlenstoffanteil die Reibungszahl weiter herabzusetzen.

Obwohl sich die bisherigen Beispiele alle mit einer Beschichtung aus B₄C befassen, kommen statt B₄C Karbide von allen der oben genannten Elemente in Frage. Im Falle von B₄C und Si bestehen die entsprechenden Targets 22 bis 28 vorzugsweise aus dem Karbid selbst. Dies kann auch für die anderen Elemente gelten.

Es ist aber auch möglich, die Karbide in der Behandlungskammer zu bilden. Hierfür müssen entsprechende Mengen an Kohlenstoff zur Verfügung gestellt werden, was am besten dadurch geschieht, daß manche Targets aus Graphit bestehen. Es können ggf. zusätzliche Targets in freien Bereichen der Behandlungskammer eingesetzt werden.

Bei den Anordnungen mit synchronisierten Drehbewegungen besteht im übrigen die Möglichkeit, auf die Seitenflächen 44 Beschichtungen aufzubauen, die aus dünnen, abwechselnden Schichten aus beispielsweise WC und C bestehen, wobei die einzelnen Schichtdicken der Karbide im Bereich zwischen 1 und 3 nm, vorzugsweise bei etwa 2 nm liegen und die Schichtdicke jeder Kohlenstoffschicht im Bereich zwischen etwa 1 nm und etwa 20 nm, vorzugsweise zwischen 2 und 4 nm liegt, wobei die oberste Schicht der Schichtfolge vorzugsweise aus Kohlenstoff besteht und mit Vorteil etwas dicker als die anderen Schichten sein darf, beispielsweise ....

Bei dieser Ausführungsform liegt der Kohlenstoff der Kohlenstoffschichten mit einem verhältnismäßig hohen Prozentsatz an sp₃-Bindungen vor, d.h. diamantartigen Bindungen, wodurch einerseits eine extrem harte Schicht mit niedriger Reibungszahl erzeugt werden kann, andererseits aber auch eine Schicht, die elastisch ist und sich daher vorzüglich für Lagerzwecke eignet. Die abwechselnden Folgen von Schichten aus WC und C ist hier nur als Beispiel genannt. Die anderen, oben genannten Elemente kommen hier genauso in Frage. Wenn man die Anzahl sp3-Bindungen zu sp2-Bindungen in Verhältnis setzt, so ist dieses Verhältnis (gemessen mit üblichen Meßmethoden wie Raman-Spektroskopie) größer als 1.

Schließlich soll darauf hingewiesen werden, daß es vorteilhaft ist, die erfindungsgemäße Beschichtung auf eine Verankerungsschicht aus beispielsweise Cr oder Ti abzulagern.

Die Ablagerung dieser Ti oder Cr-Schicht läßt sich mit der gleichen erfindungsgemäßen Behandlungskammer realisieren. Es ist nur erforderlich, ein Target aus dem entsprechenden Material vorzusehen, wobei ein solches Target zusätzlich zu den genannten Targets vorgesehen werden kann, beispielsweise in einem freien Bereich der aufschwenkbaren Kammertüren oder in einem sonst freien Bereich innerhalb des mittleren Teils 11.

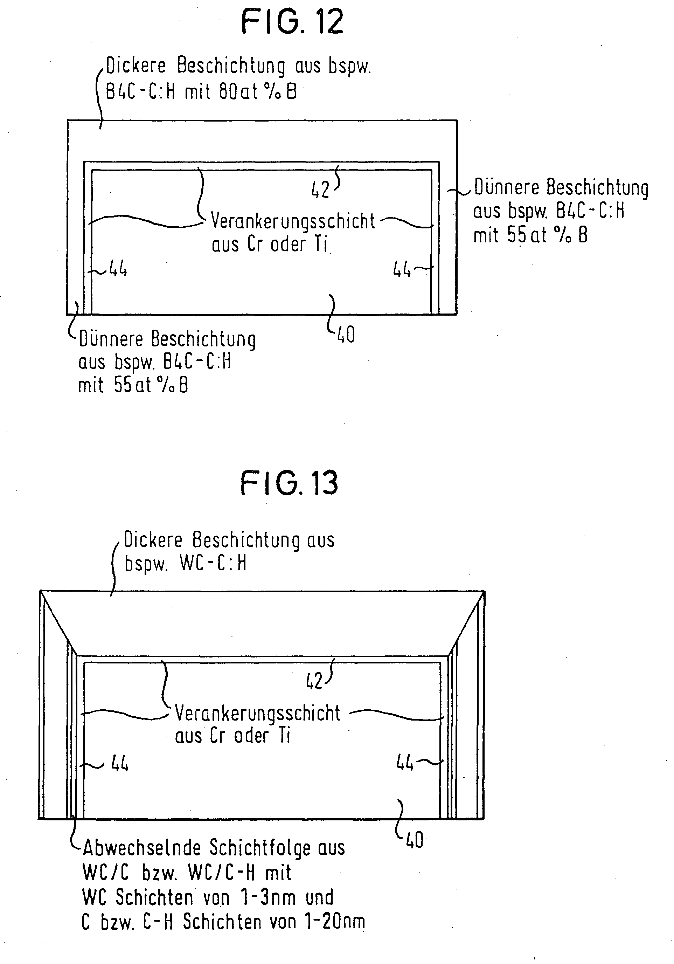

Die Fig. 12 und 13 geben Beispiele für mit dem erfindungsgemäßen Verfahren erzeugten Beschichtungen an. Sie sind selbstverständlich nicht maßstabsgetreu gezeichnet, sondern dienen lediglich dem besseren Verständnis der Erfindung.

Im übrigen soll zum Ausdruck gebracht werden, daß die verschiedenen hier genannten Beispiele rein beispielhaft angegeben wurden. Sie sind keinesfalls als eine abschließende Auflistung aller Möglichkeiten zu verstehen, die der Realisierung der Erfindung dienen. Statt dessen können alle Vorrichtungen verwendet werden, die innerhalb des Schutzumfanges der Patentansprüche fallen.

## Patentansprüche

1. Verfahren zur Herstellung eines Gegenstandes mit einem ersten Oberflächenbereich und einem zweiten Oberflächenbereich unterschiedlicher Reibungszahl unter Anwendung einer zur Durchführung von PVD-Verfahren geeigneten Behandlungskammer vorzugsweise mit einem drehbaren Träger für den Gegenstand bzw. mehreren solcher Gegenstände, wobei mindestens zwei PVD-Beschichtungsvorgänge in der Behandlungskammer gleichzeitig durchgeführt werden, wobei der erste PVD-Beschichtungsvorgang mit einem vergleichsweise gerichteten Dampffluss von einem Target oder von mehreren Targets durchgeführt wird, das bzw. die aus einem oder mehreren der Elemente B, Si, Ti, V, Cr, Zr, Nb, Mo, Hf, Ta und W, Karbiden der genannten Elemente und Kohlenstoff besteht bzw. bestehen, und der zweite PVD-Beschichtungsvorgang mit einem vergleichsweise weniger gerichteten oder nicht gerichteten Dampffluss aus Kohlenstoff durchgeführt wird, und dabei auf dem ersten Oberflächenbereich (42) eine homogene Schicht bestehend aus einem Karbid eines oder mehrerer der genannten Elemente und Kohlenstoff mit einem verhältnismäßig niedrigen Kohlenstoffanteil ausgebildet wird mit einer verhältnismäßig hohen Reibungszahl im Bereich von etwa 0,8 und auf dem zweiten Oberflächenbereich (44) eine homogene Schicht ausgebildet wird bestehend aus einem Karbid eines oder mehrerer der genannten Elemente sowie Kohlenstoff mit einem verhältnismäßig hohen Kohlenstoffanteil mit einer verhältnismäßig niedrigen Reibungszahl im Bereich von etwa 0,2.

2. Verfahren nach Anspruch 1, wobei die zwei PVD-Beschichtungsvorgänge durch Anwendung einer einzigen PVD-Beschichtungseinrichtung durchgeführt werden, derart, dass mit einem oder mehreren Targets unter Anwendung eines Kathodenzerstäubungsverfahrens oder eines Lichtbogenverdampfungsverfahrens ein Metalldampf oder Metall- und Karbidionen erzeugt und als gerichteter Dampffluss auf den Gegenstand gerichtet wird bzw. werden, wobei das Kathodenzerstäubungsverfahren oder das Lichtbogenverdampfungsverfahren zur Erzeugung eines Plasmas in der Behandlungskammer führt bzw. beiträgt und hierdurch Kohlenstoffionen und -moleküle aus einer sich in der Behandlungskammer befindlichen Kohlenwasserstoffatmosphäre in Form eines weniger gerichteten oder ungerichteten Dampfflusses entstehen und zumindest teilweise in die auf dem Gegenstand sich ausbildende Beschichtung eingebaut werden.

3. Verfahren nach Anspruch 2, wobei Magnetfelder, insbesondere die einem unbalancierten Magnetron zugeordneten Magnetfelder benutzt werden, um ein ausgedehntes Kohlenstoffionen und - moleküle an den Gegenstand lieferndes Plasma zu erzeugen.

4. Verfahren nach Anspruch 1, wobei die zwei PVD-Beschichtungsvorgänge unter Anwendung einer ersten PVD-Beschichtungseinrichtung und einer zweiten PVD-Beschichtungseinrichtung in der Behandlungskammer durchgeführt werden.

5. Verfahren nach Anspruch 4, wobei der Gegenstand oder mehrere Gegenstände auf einem drehbaren Träger angeordnet ist bzw. sind und durch eine Drehbewegung des Trägers durch den vergleichsweise gerichteten Dampffluss der ersten PVD-Beschichtungseinrichtung hindurch bewegt werden, wobei diese Drehbewegung entweder eine einfache Drehbewegung ist, dass der Gegenstand bzw. jeder Gegenstand eine vorgegebene, zumindest im wesentlichen konstante effektive Orientierung zum genannten Dampffluss aufweist oder eine komplexe Drehbewegung ist, beispielsweise eine Drehbewegung, bei der der Gegenstand bzw. jeder Gegenstand um die eigene Achse gedreht wird, wobei im Falle einer komplexeren Drehbewegung die einzelnen Drehbewegungen so synchronisiert sind, dass der Gegenstand bzw. jeder Gegenstand ebenfalls eine vorgegebene, zumindest im wesentlichen konstante effektive Orientierung zum genannten Dampffluss aufweist.

6. Verfahren nach Anspruch 4 oder 5, wobei es sich bei der ersten, einen vergleichsweise gerichteten Dampffluss erzeugenden PVD-Beschichtungseinrichtung um eine oder mehrere der folgenden Beschichtungseinrichtungen handelt:
- eine Lichtbogenverdampfungseinrichtung,
- eine Kathodenzerstäubungseinrichtung, beispielsweise in Form eines Magnetrons oder eines unbalanzierten Magnetrons,
- eine lineare Ionenquelle, insbesondere eine solche zur Erzeugung von Kohlenstoffionen, wie beispielsweise eine Plasma erzeugende Quelle mit Heizfilament.

7. Verfahren nach einem der vorhergehenden Ansprüche 4 bis 6, wobei es sich bei der zweiten, einen vergleichsweise weniger gerichteten oder nicht gerichteten Dampffluss erzeugenden PVD-Beschichtungseinrichtung um eine oder mehrere der folgenden Beschichtungseinrichtungen handelt:
- eine Ionenquelle, insbesondere zur Erzeugung von Kohlenstoffionen aus einem der Behandlungskammer zugeführten gasförmigen Kohlenwasserstoff,
- eine Plasmaquelle, beispielsweise mit einem von einer Mikrowellenquelle, insbesondere einer Hochleistungs-Mikrowellenquelle erzeugten Plasma.

8. Verfahren nach einem der vorhergehenden Ansprüche, wobei bei Anwendung von Bor die Beschichtung des ersten Oberflächenbereiches zumindest im wesentlichen etwa 80 % Bor enthält und der Rest von 20 % aus Kohlenstoff und eingebautem Wasserstoff sowie etwaigen Verunreinigungen besteht, während der zweite Oberflächenbereich eine Beschichtung aus etwa 55 % Bor aufweist und der Rest von 45 % aus Kohlenstoff und eingebautem Wasserstoff sowie etwaigen Verunreinigungen besteht.

9. Verfahren nach einem der vorhergehenden Ansprüche, wobei bei Anwendung von Wolfram die Beschichtung des ersten Oberflächenbereiches zumindest im wesentlichen etwa 50 % Wolfram enthält und der Rest von 50 % aus Kohlenstoff und eingebautem Wasserstoff sowie etwaigen Verunreinigungen besteht, während der zweite Oberflächenbereich eine Beschichtung aus etwa 15 % Wolfram aufweist und der Rest von 85 % aus Kohlenstoff und eingebautem Wasserstoff sowie etwaigen Verunreinigungen besteht.

10. Verfahren nach einem der vorhergehenden Ansprüche, wobei eine Verankerungsschicht aus beispielsweise Cr oder Ti auf den genannten Oberflächenbereichen des Gegenstandes bzw. jedes Gegenstandes vor Erzeugung der jeweiligen Beschichtungen aufgebaut wird.

11. Verfahren nach Anspruch 10, wobei die Dicke der Verankerungsschicht auf der ersten Oberfläche im Bereich von 0,1 µm bis 1 µm und auf der zweiten Oberfläche im Bereich von 0,1 µm bis 1 µm liegt.

12. Verfahren nach einem der vorhergehenden Ansprüche, wobei die Dicke der Beschichtung auf den beiden Oberflächenbereichen einschließlich einer etwaigen Verankerungsschicht insgesamt zwischen 0,5 µm und 5 µm liegt.

13. Gegenstand nach einem oder mehreren der vorgenannten Verfahren hergestellt, mit einem ersten und einem zweiten Oberflächenbereich, wobei auf dem ersten Oberflächenbereich eine homogene Schicht bestehend aus einem Karbid eines oder mehreren der genannten Elemente und Kohlenstoff mit einem verhältnismäßig niedrigen Kohlenstoffanteil ausgebildet ist, wodurch eine verhältnismäßig hohe Reibungszahl im Bereich von etwa 0,8 vorliegt, und auf dem zweiten Oberflächenbereich eine homogene Schicht ausgebildet ist bestehend aus einem Karbid eines oder mehreren der genannten Elemente sowie Kohlenstoff mit einem verhältnismäßig hohen Kohlenstoffanteil, wodurch eine verhältnismäßig niedrige Reibungszahl im Bereich von 0,2 vorliegt.

14. Gegenstand nach Anspruch 13, wobei bei Anwendung von Bor die Beschichtung des ersten Oberflächenbereiches zumindest im wesentlichen etwa 80 % Bor enthält und der Rest von 20 % aus Kohlenstoff und eingebautem Wasserstoff sowie etwaigen Verunreinigungen besteht, während der zweite Oberflächenbereich eine Beschichtung aus etwa 55 % Bor aufweist und der Rest von 45 % aus Kohlenstoff und eingebautem Wasserstoff sowie etwaigen Verunreinigungen besteht.

15. Gegenstand nach Anspruch 13, wobei bei Anwendung von Wolfram die Beschichtung des ersten Oberflächenbereiches zumindest im wesentlichen etwa 50 % Wolfram enthält und der Rest von 50 % aus Kohlenstoff und eingebautem Wasserstoff sowie etwaigen Verunreinigungen besteht, während der zweite Oberflächenbereich eine Beschichtung aus etwa 15 % Wolfram aufweist und der Rest von 85 % aus Kohlenstoff und eingebautem Wasserstoff sowie etwaigen Verunreinigungen besteht.

16. Gegenstand nach einem der vorhergehenden Ansprüche 13 bis 15, wobei eine Verankerungsschicht aus beispielsweise Cr oder Ti auf den genannten Oberflächenbereichen des Gegenstandes bzw. jedes Gegenstandes aufgebaut wird vor Erzeugung der jeweiligen Beschichtungen.

17. Gegenstand nach Anspruch 16, wobei die Dicke der Verankerungsschicht auf der ersten Oberfläche im Bereich von 0,1 bis 1 µm und auf der zweiten Oberfläche im Bereich von 0,1 bis 1 µm liegt.

18. Gegenstand nach einem der vorhergehenden Ansprüche 13 bis 17, wobei die Dicke der Beschichtung auf dem ersten Oberflächenbereich einschließlich einer etwaige Verankerungsschicht insgesamt zwischen 1 und 5 µm liegt und die Dicke der Beschichtung auf dem zweiten Oberflächenbereich einschließlich einer etwaigen Verankerungsschicht zwischen 1 und 5 µm liegt.

19. Gegenstand nach einem der vorhergehenden Ansprüche 13 bis 18, wobei auf dem zweiten Oberflächenbereich eine Mehrschichtstruktur ausgebildet ist und aus abwechselnden, dünnen Schichten aus einem Karbid eines oder mehreren der genannten Elemente und Kohlenstoff besteht, wobei die Karbidschichten aus einem Karbid mindestens eines Elements in Form eines Metalls und/oder Silizium und/oder Bor gebildet sind, die Schichtdicke jeder Kohlenstoffschicht der Schichtfolge im Bereich zwischen etwa 1 nm und etwa 20 nm, vorzugsweise zwischen 2 und 4 nm liegt, wobei die oberste Schicht der Schichtfolge vorzugsweise aus Kohlenstoff besteht und mit Vorteil etwas dicker als die anderen Schichten sein darf, beispielsweise 500 nm, die Schichtdicke der Karbidschichten im Bereich zwischen 1 und 3 nm, vorzugsweise bei etwa 2 nm liegt und der Kohlenstoff der Kohlenstoffschicht vorwiegend sp₃-Bindungen aufweist.
